# EUROPEAN PATENT SPECIFICATION

(11) **EP 4 562 471 B1**
(45) Date of publication and mention of the grant of the patent: **11.11.2026**
(21) Application number: 23750742.1
(22) Date of filing: 17.07.2023
(51) Int. Cl.: G02F 1/1335

(54) **LIGHT CONTROL FILM**
LICHTSTEUERFILM
FILM DE COMMANDE DE LUMIÈRE

(30) Priority: 29.07.2022 US 202263393420 P
(43) Date of publication of application: 04.06.2025
(73) Proprietor: 3M Innovative Properties Company, Saint Paul, Minnesota 55133-3427 (US)
(72) Inventor: LIU, Tao, Saint Paul, Minnesota 55133-3427 (US); GOTRIK, Kevin W., Saint Paul, Minnesota 55133-3427 (US); JOHNSON, Nicholas A., Saint Paul, Minnesota 55133-3427 (US); BOYD, Gary T., Saint Paul, Minnesota 55133-3427 (US)
(74) Representative: Vossius & Partner Patentanwälte Rechtsanwälte mbB
(86) International application number: PCT/IB2023/057283
(87) International publication number: WO 2024/023633

(56) References cited:
- US-A- 4 772 097
- US-A1- 2019 265 395
- US-B1- 9 740 018

## Description

### Field of the Invention

Provided are light control films for display systems, and particularly light control films for display systems used in outdoor environments.

### Background

Flat panel displays have become widespread throughout our daily lives. Mobile phones, notebooks, monitors, televisions, traffic signals, and electronic signage all extensively use flat panel displays. These have been enabled by foundational technologies such as liquid crystal displays, plasma display panels, light emitting diodes, organic light emitting diodes, and field emission displays. Each of these technologies has its own unique properties and applications.

Liquid Crystal Displays (LCDs) and organic light emitting diodes (OLEDs) are two of the most common display technologies. LCDs are flat panel displays that utilize the optical properties of liquid crystals. LCDs typically use a reflective film to modulate light that is seen by an observer. Since LCDs do not emit light on their own, light is generally provided by reflection of ambient light entering the display from the front or, alternatively, a backlight module emitting light from behind the LCD. OLEDs are electroluminescent devices made from organic materials. Electrons and holes recombine to produce light within these emissive materials, with the electronic bandgap of these materials determining the wavelength of the emitted light. Unlike the liquid crystal panels in LCDs, OLEDs do not require a separate light source.

In some applications, it is useful to use a light control film to manage the viewing angle, which is based on the directionality of light provided by the flat panel display. Light control film can be used to create privacy, control reflections, or improve display contrast in the displayed image. This functionality is enabled by a rib-shaped louvers in the film that only permit light to pass through over a certain angular range relative to the major surface of the film. These louvers are made from light-absorbing material and are separated from each other by a light-transmitting material along the plane of the major surface, as for example disclosed in US 9,740,018 B1.

### Summary

In certain applications, light control films may be used outdoors with the presence of strong sunlight. Due to the absorptive nature of light control films, their reliability has become a concern when most of the sunlight across its spectra is absorbed and turned into heat. Such heat can induce significant thermal damage to the film. For example, heat generated by solar radiation can lead to significant thermal expansion, distorting louver geometry and impairing performance. Further, excess heat can also degrade the polymer materials used in the display films, resulting in yellowing, haze, or even de-lamination over time.

When the film is exposed to light, a great deal of heat is attributable to the absorption of the light energy by the louvers. This problem can be mitigated by disposing a reflective layer on the areas of the exposed major surface of the film represented by the louvers. Since the incident light is reflected instead of being absorbed by the film, the degree of thermal gain can be substantially reduced, avoiding heat damage and extending the longevity of the film. Since the reflective layer is applied only on the top surfaces of louvers, overall transmission of the light through the film can be preserved.

In a primary aspect, a film assembly is provided as defined in appended claim 1.

### Brief Description of the Drawings

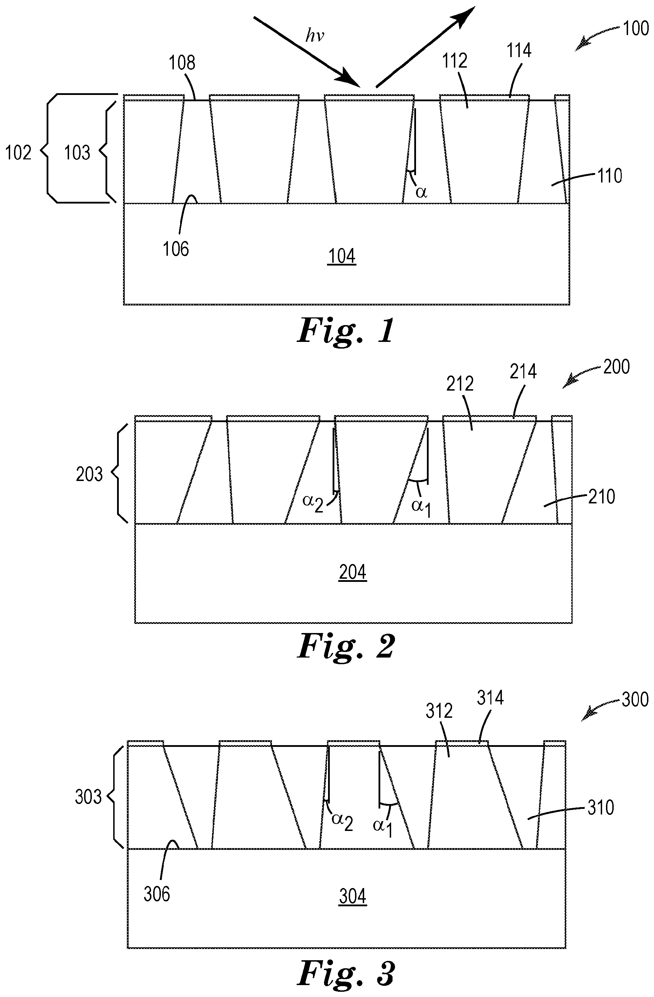

FIGS. 1-6 are cross-sectional views of film assemblies according to various exemplary embodiments.

Repeated use of reference characters in the specification and drawings is intended to represent the same or analogous features or elements of the disclosure. It should be understood that numerous other modifications and embodiments can be devised by those skilled in the art, which fall within the scope and spirit of the principles of the disclosure. The figures may not be drawn to scale.

### Detailed Description

As used herein, the terms "preferred" and "preferably" refer to embodiments described herein that can afford certain benefits, under certain circumstances. However, other embodiments may also be preferred, under the same or other circumstances. Furthermore, the recitation of one or more preferred embodiments does not imply that other embodiments are not useful and is not intended to exclude other embodiments from the scope of the invention.

As used herein and in the appended claims, the singular forms "a," "an," and "the" include plural referents unless the context clearly dictates otherwise. Thus, for example, reference to "a" or "the" component may include one or more of the components and equivalents thereof known to those skilled in the art. Further, the term "and/or" means one or all of the listed elements or a combination of any two or more of the listed elements.

It is noted that the term "comprises", and variations thereof do not have a limiting meaning where these terms appear in the accompanying description. Moreover, "a," "an," "the," "at least one," and "one or more" are used interchangeably herein. Relative terms such as left, right, forward, rearward, top, bottom, side, upper, lower, horizontal, vertical, and the like may be used herein and, if so, are from the perspective observed in the particular drawing. These terms are used only to simplify the description, however, and not to limit the scope of the invention in any way.

Reference throughout this specification to "one embodiment," "certain embodiments," "one or more embodiments" or "an embodiment" means that a particular feature, structure, material, or characteristic described relating to the embodiment is included in at least one embodiment of the invention. Thus, the appearances of the phrases such as "in one or more embodiments," "in certain embodiments," "in one embodiment" or "in an embodiment" in various places throughout this specification are not necessarily referring to the same embodiment of the invention. Unless otherwise specified, all measurements are assumed to be made at ambient temperature (21°C) and pressure (101.3 kilopascals).

A display system according to one exemplary embodiment is illustrated in FIG. 1 and herein designated by the numeral 100. The display system 100 has a multilayered construction that broadly includes a light control film assembly 102 and an optical display 104. The film assembly 102 and the optical display 104 may be provided collectively or as individual components. Optionally but not shown, an bonding layer such as an optically-clear adhesive can be provided between the film assembly 102 and the optical display 104 to couple these layers to each other. In certain embodiments, the film assembly 102 can be provided with a pressure-sensitive adhesive pre-coated thereon for convenient application onto an optical display or other substrate.

As shown in this cross-sectional view, the film assembly 102 includes a light input surface 106 facing toward the optical display 104 and a light output surface 108 facing away from the optical display 104. Each of the light input surface 106 and the light output surface 108 are coextensive with the major surfaces of the film assembly 102. The film assembly 102 includes a louver layer 103 extending across the optical display 104 and having a first major surface facing toward the optical display 104 and a second major surface facing toward a reflective layer 114 disposed on the louver layer 103. In this manner, the louver layer is disposed between the optical display 104 and the reflective layer 114.

The louver layer 103 includes a plurality of light-transmitting regions 110 and a plurality of light-absorbing regions 112 arranged transversely according to an alternating two-dimensional pattern. The light-transmitting regions 110 are ideally optically clear, while the light-absorbing regions 112 are preferably completely light blocking. In some embodiments, the light-transmitting regions 110 can transmit at least 80 percent, at least 90 percent, at least 95 percent, at least 98 percent, or at least 99 percent, and up to 100 percent of incident light. In some embodiments, the light-absorbing regions 112 can absorb at least 80 percent, at least 90 percent, at least 95 percent, at least 98 percent, or at least 99 percent, and up to 100 percent of incident light. The above values can be obtained by measuring light transmission through a continuous film of the light-transmitting or light-absorbing material having equivalent thickness to that of the louvers.

The reflective layer 114, which is not coextensive with the major surface of the film assembly 100, is disposed on and directly contacts the light-absorbing regions 112 along the light output surface 108, thereby reducing absorption of incident light by the light-absorbing regions 112. In a preferred embodiment, and as shown, the reflective layer 114 is selectively disposed on the light-absorbing regions 112 and not on the light-transmitting regions 110 along the light output surface 108. It is to be understood that these layers need not be in perfect registration with each other, and so the light-absorbing regions 112 may or may not be precisely coextensive with the reflective layer 114.

In this embodiment, the two-dimensional pattern is represented by a plurality of parallel, riblet-shaped louvers having a generally trapezoidal shape in cross-section as shown in FIG. 1, where there is a taper on both louver sidewalls along the thickness dimension of the film assembly 102. Here, the cross-sections of the louvers have approximately a constant size and shape along their lengths. This need not always be the case. The size, shape, and orientation of the louvers can be adjusted to any suitable configuration, as known in the art, to define permissible viewing angles available to an observer.

The size, pitch and direction/degree of taper in the sidewalls of each louver represented by light-absorbing regions 112 generally depends on the targeted range of viewing angles. These properties are not particularly restricted, and can be customized as appropriate for the application at hand. The sidewall angle (i.e., slant angle a) is defined relative to a normal vector to the major surfaces of the film assembly 102 as shown, and can be from -50 degrees to +50 degrees, from -45 degrees to +45 degrees, from -40 degrees to +40 degrees, or in some embodiments less than, equal to, or greater than -50 degrees, -45, -40, -35, -30, -25, -20, -15, -10, -5, 0, +5, +10, +15, +20, +25, +30, +35, +40, +45, or +50 degrees. The light-absorbing regions 112 can be widest along the light output surface 108 (as shown in FIG. 1) or alternatively along the light input surface 106.

FIGS. 2 and 3 illustrate display systems using louver layers with alternative configurations. In FIG. 2, a display system 200 uses a louver layer 203 having light-transmitting regions 210 and light-absorbing regions 212 that are asymmetrically tapered. In this embodiment, the sidewall angle a₁ on one side of each louver greatly exceeds the sidewall angle a₂ on its opposing side. In FIG. 3, a display system 300 uses a louver layer 303 that has an inverted taper relative to that shown in FIG. 2 in which the transverse dimension of light-absorbing regions 312 increases rather than decreases when approaching light input surface 306. According to the convention used herein, both a₁ and a₂ in FIG. 3 have negative values, with angle a₁ here being significantly more negative than angle a₂. As in previous embodiments, the light-absorbing regions 212, 312 are capped with corresponding reflective layers 214, 314.

The spacing, or pitch, of the louvers is defined as the nominal center-to-center distance between neighboring louvers and is generally selected based on the desired aesthetics and technical properties of the optical display 104. The pitch can be from 10 micrometers to 100 micrometers, from 20 micrometers to 70 micrometers, from 30 micrometers to 50 micrometers, or in some embodiments less than, equal to, or greater than 10 micrometers, 15, 20, 25, 30, 35, 40, 45, 50, 55, 60, 65, 70, 75, 80, 85, 90, 95, or 100 micrometers.

The relative width of the louvers (or average width in instances where the louvers are tapered) can be adjusted depending on the desired overall transmissivity of the light control film 102. The light-absorbing regions, and independently the reflective layer 114, can extend over from 10 percent to 90 percent, from 20 percent to 80 percent, from 30 percent to 70 percent, or in some embodiments less than, equal to, or greater than 10 percent, 15, 20, 25, 30, 35, 40, 45, 50, 55, 60, 65, 70, 75, 80, 85 or 90 percent of the light output surface 108.

Finally, the louver layer 103 can have any suitable thickness. Based on their principle of operation, the louvers must have a certain minimal thickness to block transmission of light rays along certain angles of incidence. Use of a louver layer that is unnecessarily thick, however, can potentially worsen the problem of light absorption by creating larger sidewall surfaces over which the louvers can absorb incident radiation. The thickness can be from 30 micrometers to 300 micrometers, from 50 micrometers to 200 micrometers, from 70 micrometers to 150 micrometers, or in some embodiments can be less than, equal to, or greater than 30 micrometers, 35, 40, 45, 50, 60, 70, 80, 90, 100, 110, 120, 150, 170, 200, 220, 250, 270, or 300 micrometers.

The louvers need not be riblet-shaped. In alternative embodiments, the louvers may be pillar-shaped or otherwise have discontinuities along their length (i.e., the dimension perpendicular to the plane of the page in FIG. 1). The louvers may also have a bent or curved configuration where, for example, the film assembly 100 is to be used in a non-planar display application. The louvers also need not be identical to each other, and may have different cross-sectional shapes or dimensions.

In an exemplary embodiment, each light-absorbing region 112 of film assembly 102 comprises carbon black dispersed in a polymeric matrix. Useful compositions for the polymeric matrix include acrylic and methacrylic polymers. Without limitation, these include urethane (meth)acrylate-based resins, polyester (meth)acrylate-based resins, and epoxy (meth)acrylate-based resins, hydroxy (meth)acrylates including 2-hydroxyethyl (meth)acrylate, 2-hydroxymethyl (meth)acrylate, 2-hydroxypropyl (meth)acrylate, glycidyl (meth)acrylate and pentaerythritol tri(meth)acrylate, 2-ethylhexyl carbitol (meth)acrylate, 2-hydroxyethyl acrylate, butylene glycol monoacrylate, polyethylene glycol (meth)acrylate, cyclopentenyl (meth)acrylate, cyclopentyl (meth)acrylate, hexanediol (meth)acrylate, isobornyl (meth)acrylate, isobutyl (meth)acrylate, isooctyl (meth)acrylate, isodecyl (meth)acrylate, isostearyl (meth)acrylate, cyclopentyl di(meth)acrylate, hexanediol di(meth)acrylate, isobornyl di(meth)acrylate, butanediol di(meth)acrylate, hexanediol di(meth)acrylate, neopentyl glycol di(meth)acrylate, nonylphenoxypolyethylene glycol (meth)acrylate, 1, 9-nonanediol di(meth)acrylate, 1,0-decanediol di(meth)acrylate, EO-modified bisphenol A di(meth)acrylate, PO-modified bisphenol A di(meth)acrylate, EO-modified neopentyl glycol di(meth)acrylate, PO-modified neopentyl glycol di(meth)acrylate, polypropylene glycol di(meth)acrylate, tricyclodecanedimethanol di(meth)acrylate, pentaerythritol tri(meth)acrylate, trimethylolpropane tri(meth)acrylate, EO-modified trimethylolpropane tri(meth)acrylate and PO-modified trimethylolpropane tri(meth)acrylate. The polymeric matrix can also be made from styrene-acrylonitrile, cellulose acetate butyrate, cellulose acetate propionate, cellulose triacetate, polyethersulfone, polymethylmethacrylate, polyurethane, polyester, polycarbonate, polyvinyl chloride, polystyrene, polyethylene naphthalate, copolymers or blends based on naphthalene dicarboxylic acids, polyolefin-based materials (such as cast or oriented films of polyethylene, polypropylene, and polycycloolefin), and polyimide.

The light-absorbing regions 112 can comprise other pigments or dyes besides carbon black, or a combination thereof. Other pigments may include particles or other scattering elements in loadings sufficient to block light transmission through the light-absorbing region 112. The light-transmitting regions 110 can be made of any suitable transparent polymeric material. Suitable materials can include the same materials used for the polymeric matrix of the light-absorbing regions 112.

With respect to reflectance properties, the reflective layer 114 can be anywhere in the range between a specular reflective coating and a diffuse reflective coating. In some embodiments, the reflective layer 114 is a specular reflective film such as provided by a mirror coating. Useful mirror coatings can be obtained, for example, by depositing onto the louver layer 103 a smooth layer of metal. Coating technologies for metal are known, and any suitable method may be used to provide such a coating onto the louver layer 103, including physical and chemical vapor deposition, sputtering, electroplating, and combinations thereof. Precise, selective deposition of the reflective layer 114 onto the desired areas can be achieved by appropriately masking the louver layer 103 to prevent coating along certain pre-determined areas, such as over the light-transmitting regions 110. This can be carried out using a photoresist and known lithographic techniques, for example.

Other embodiments are also possible. For example, the reflective layer 114 may be disposed first on a support layer that is then laminated onto the louver layer 103. The reflective layer 114 itself can be made from a single layer or two or more layers, such as two more metal coatings. Use of a tie layer or primer layer can be advantageously used in some configurations to improve interlayer adhesion and provide a more durable film assembly 102, for example.

In general, the reflective layer 114 should have a thickness that is small relative to the thickness of the louver layer 103. Minimizing this thickness can help avoid interfering with the operation of the louver layer 103 in restricting viewing angle. The thickness of the reflective layer 114 can be from 10 nanometers to 1000 nanometers, from 30 nanometers to 500 nanometers, from 100 nanometers to 300 nanometers, or in some embodiments less than, equal to, or greater than 10 nanometers, 15, 20, 25, 30, 40, 50, 60, 70, 80, 90, 100, 110, 120, 150, 170, 200, 250, 300, 350, 400, 450, 500, 600, 700, 800, 900, or 1000 nanometers.

The reflective layer 114 can provide reflection that is specular, semi-specular, or Lambertian. With specular reflection, the angle of reflection is the same as the angle of incidence. A semi-specular reflector offer a slightly more diffuse reflection with a wider distribution of light, while a Lambertian reflector provides an ideal matte reflection in which the brightness appears to an observer to be approximately the same regardless of the observer's angle of view.

There are advantages to using a reflective layer 114 that is a specular-mirror or specular-particulate coating, rather than a diffuse coating. With the specular coating, the reflected light can be directed along desired directions where the directionality of the light source is known. There are also potential advantages to using a diffuse reflector, however. In some cases, using a specular reflector can result in undesirable glare for an observer of the display system, particularly when the directionality of the light source is unknown or otherwise difficult to predict. In these cases, the scattering of light can spread the reflected light energy over a wide angular range and provide a more consistent appearance to an observer.

In some embodiments, the reflective layer 114 is a broadband reflector that reflects light over a broad range of wavelengths. Alternatively, the reflective layer 114 can be wavelength-specific in its reflection of light. As an example, the reflective layer 114 can reflect infrared radiation while allowing light of other wavelengths to pass through. A benefit of allowing certain wavelengths of light to pass through the reflective layer 114 is the ability to reduce the severity of glare from reflected light being directed toward the observer of the display system 100. Since visible light is of principal concern when viewing the display, it can be advantageous to absorb light within the visible light spectrum while reflecting light outside the visible light spectrum.

Constituent layers in the aforementioned display systems can be attached to each other directly or using an adhesive bond (not shown). In instances where an adhesive is used, it generally preferred to use an optically clear adhesive. Any of the constituent layers can also be fabricated on a release surface, separated therefrom, and assembled with adjoining layers.

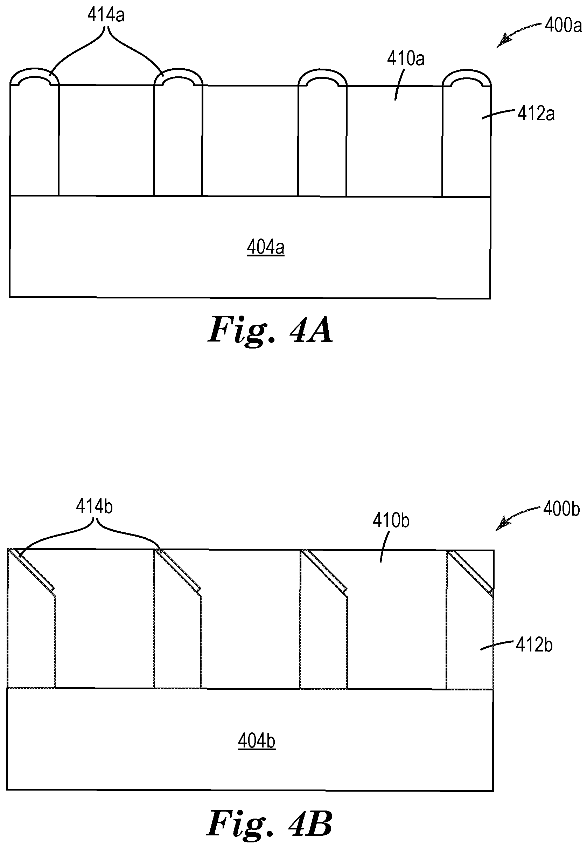

FIGS. 4A and 4B show two further alternative film assemblies 400a, 400b having alternative reflector shapes. In FIG. 4A, the film assembly 400a has alternating light-absorbing regions 412a and light-transmitting regions 412b, each disposed on an optical display 404a as in previous embodiments. In this instance, however, the light-absorbing regions 412a are capped with a reflective layer 414a that has a curved (or lenticular) configuration in which its exposed surface is convex, as shown. Although not shown explicitly shown, the reflective layer could also have an exposed surface that is concave. In FIG. 4B, where light-absorbing regions 412b and light-transmitting regions 412b are disposed on optical display 404a, the light-absorbing regions 412b are capped with a reflective layer 414b that has a wedge-faceted configuration such that its reflective surface is at least partially embedded within a polymeric matrix and is tilted at an acute angle relative to the major surface of the film. Suitable acute angles can be from 10 degrees to 50 degrees, from 15 degrees to 45 degrees, or from 20 degrees to 40 degrees. Each of the above embodiments enable incident light to be diffused or reflected away at angles that avoid or reduce glare to an observer.

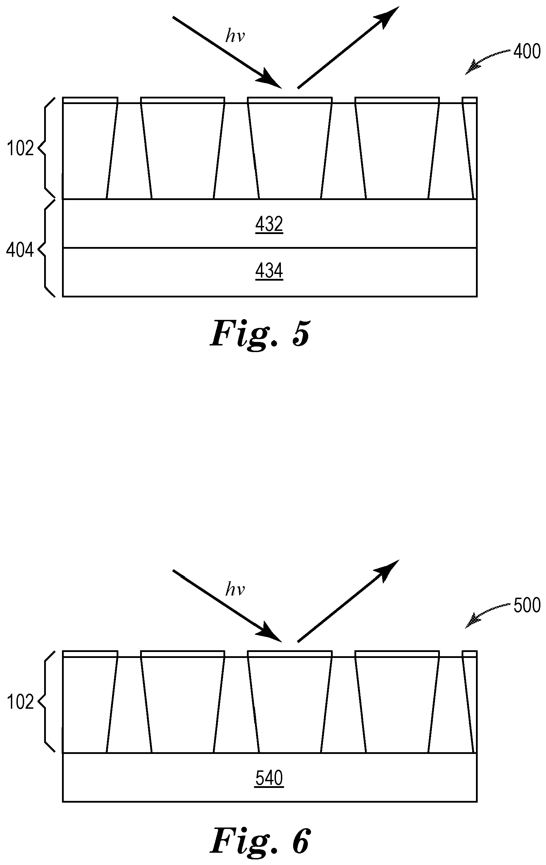

FIGS. 5 and 6 show the film assembly 102 disposed on different optical displays. These are merely intended to be exemplary, and it to be understood that any other optical displays configured to form an image are also possible. Other useful optical displays can include, for example, micro light emitting diodes or mini light emitting diodes.

FIG. 5 shows a display system 400 where the film assembly 102 is disposed on a liquid crystal display (LCD) 404 comprised of a liquid crystal panel 432 extending across an underlying light source 434. In this configuration, backlighting from the light source 434 is necessary because the liquid crystal panel 432, by its nature, does not generate light on its own. A color filter is typically used to provide colored light based on the additive combination of primary colors red, green, and blue. The LCD panel includes a multiplicity of pixels, each subdivided into subpixels aligned with the primary colors, where each subpixel only transmits light of their respective primary color and absorbs all other colors. The coordinated presentation of pixels can thus generate the desired image. The type of light source 434 used is not particularly restricted and can be made from an array of cold-cathode fluorescent lamps or light emitting diodes.

FIG. 6 shows alternative display system 500 where the film assembly 102 is disposed on an OLED array 540. The OLED array 540 are also known in the art. OLED devices generate light by electron-hole recombination, with emission of different colors made possible through their molecular design. Being self-emissive, they do not require a separate device for illumination. Technical advantages enjoyed by OLED devices include faster response time, broader possible viewing angles, and fewer components in construction.

The aforementioned embodiments, described by illustration and example, can be particularly useful in outdoor applications where flat panel displays are exposed to a full spectrum of light. The broadband nature of sunlight, along with the absorptive nature of the light-absorbing regions of the louver layer, can lead to significant adverse impacts on both aesthetic and functional aspects of the display. For example, the heat generated by solar radiation can lead to significant thermal expansion, distorting louver geometry and impairing performance. Further, excess heat can also degrade the polymer materials used in the display films, resulting in yellowing, haze, or even de-lamination over time. In many situations, the optical display itself is vulnerable to heat damage; in certain cases, prolonged heat exposure can cause premature failure of the display. With the optical display component generally being far more valuable than the light control film assembly, the cost of poor thermal management can be high. For all these reasons, the provided light control film assemblies represent a significant and unexpected technical benefit over the state of the art.

The preceding description, given in order to enable one of ordinary skill in the art to practice the claimed disclosure, is not to be construed as limiting the scope of the disclosure, which is defined by the claims.

## Claims

1. A film assembly comprising the following layers:
an optical display (104) configured to form an image:
a louver layer (103) extending across the optical display and comprising a plurality of light-transmitting regions (110) and light-absorbing regions (112) arranged transversely according to an alternating two-dimensional pattern; and
a reflective layer (114) extending across the louver layer such that the louver layer is disposed between the optical display and the reflective layer, wherein the reflective layer is preferentially disposed on the light-absorbing regions to reduce absorption of incident light by the light-absorbing regions, and **characterised in that**
the reflective layer is selectively disposed on the light-absorbing regions and is not disposed on the light-transmitting regions.

2. The film assembly of claim 1, wherein the reflective layer is a broadband reflective layer.

3. The film assembly of claim 1, wherein the reflective layer is a wavelength-specific reflector.

4. The film assembly of claim 3, wherein the reflective layer selectively reflects light outside of the visible light spectrum.

5. The film assembly of any one of claims 1-4, wherein the optical display comprises
a light source; and
a liquid crystal panel extending across the light source.

6. The film assembly of any one of claims 1-4, wherein the optical display comprises an organic light-emitting diode array, micro light emitting diode, or mini light emitting diode.

7. The film assembly of any one of claims 1-6, wherein the light-absorbing regions are tapered along their thickness dimension when viewed in cross-section.

8. The film assembly of claim 7, wherein the louver layer has a first major surface facing toward the reflective layer and a second major surface facing the optical display and further wherein the light-absorbing regions are widest along the first major surface.

9. The film assembly of claim 7, wherein the louver layer has a first major surface facing toward the reflective layer and a second major surface facing the optical display and further wherein the light-absorbing regions are widest along the second major surface.

10. The film assembly of claim 8 or 9, wherein the light-absorbing regions have a slant angle of from -50 degrees to +50 degrees relative to a normal vector on the first or second major surface.

11. The film assembly of any one of claims 1-10, wherein the reflective layer directly contacts the light-absorbing regions of the louver layer.

12. The film assembly of any one of claims 1-11, wherein the reflective layer is oriented at an acute angle relative to a major surface of the film assembly.

13. The film assembly of any one of claims 1-11, wherein the reflective layer has an exposed surface that is either concave or convex.

14. The film assembly of any one of claims 1-11, wherein the reflective layer extends over from 10 percent to 90 percent of a major surface of the film assembly.

15. The film assembly of any one of claims 1-14, wherein the reflective layer has a thickness of from 10 nanometers to 1000 nanometers.

## Patentansprüche

1. Folienanordnung, aufweisend die folgenden Schichten:
eine optische Anzeige (104), die konfiguriert ist, ein Bild zu bilden:
eine Klappenschicht (103), die sich über die optische Anzeige erstreckt und eine Mehrzahl von lichtdurchlässigen Bereichen (110) und lichtabsorbierenden Bereichen (112) aufweist, die entsprechend einem alternierenden zweidimensionalen Muster quer eingerichtet sind; und
eine reflektierende Schicht (114), die sich derart über die Klappenschicht erstreckt, dass die Klappenschicht zwischen der optischen Anzeige und der reflektierenden Schicht angeordnet ist, wobei die reflektierende Schicht vorzugsweise auf den lichtabsorbierenden Bereichen angeordnet ist, um eine Absorption von einfallendem Licht durch die lichtabsorbierenden Bereiche zu verringern, und **dadurch gekennzeichnet, dass** die reflektierende Schicht auf den lichtabsorbierenden Bereichen selektiv angeordnet ist und nicht auf den lichtdurchlässigen Bereichen angeordnet ist.

2. Folienanordnung nach Anspruch 1, wobei die reflektierende Schicht eine breitbandige reflektierende Schicht ist.

3. Folienanordnung nach Anspruch 1, wobei die reflektierende Schicht ein wellenlängenspezifischer Reflektor ist.

4. Folienanordnung nach Anspruch 3, wobei die reflektierende Schicht Licht außerhalb des sichtbaren Lichtspektrums selektiv reflektiert.

5. Folienanordnung nach einem der Ansprüche 1 bis 4, wobei die optische Anzeige aufweist
eine Lichtquelle; und
eine Flüssigkristallplatte, die sich über die Lichtquelle erstreckt.

6. Folienanordnung nach einem der Ansprüche 1 bis 4, wobei die optische Anzeige ein organisches Leuchtdioden-Array, eine Mikroleuchtdiode oder eine Minileuchtdiode aufweist.

7. Folienanordnung nach einem der Ansprüche 1 bis 6, wobei die lichtabsorbierenden Bereiche, wenn in dem Querschnitt betrachtet, entlang ihrer Dickenabmessung verjüngt sind.

8. Folienanordnung nach Anspruch 7, wobei die Klappenschicht eine erste Hauptoberfläche, die der reflektierenden Schicht zugewandt ist, und eine zweite Hauptoberfläche, die der optischen Anzeige zugewandt ist, vorweist, und ferner wobei die lichtabsorbierenden Bereiche entlang der ersten Hauptoberfläche am breitesten sind.

9. Folienanordnung nach Anspruch 7, wobei die Klappenschicht eine erste Hauptoberfläche, die der reflektierenden Schicht zugewandt ist, und eine zweite Hauptoberfläche, die der optischen Anzeige zugewandt ist, vorweist, und ferner wobei die lichtabsorbierenden Bereiche entlang der zweiten Hauptfläche am breitesten sind.

10. Folienanordnung nach Anspruch 8 oder 9, wobei die lichtabsorbierenden Bereiche einen Neigungswinkel von -50 Grad bis +50 Grad relativ zu einem normalen Vektor auf der ersten oder der zweiten Hauptoberfläche vorweisen.

11. Folienanordnung nach einem der Ansprüche 1 bis 10, wobei die reflektierende Schicht die lichtabsorbierenden Bereiche der Klappenschicht direkt kontaktiert.

12. Folienanordnung nach einem der Ansprüche 1 bis 11, wobei die reflektierende Schicht in einem spitzen Winkel relativ zu einer Hauptoberfläche der Folienanordnung ausgerichtet ist.

13. Folienanordnung nach einem der Ansprüche 1 bis 11, wobei die reflektierende Schicht eine freiliegende Oberfläche vorweist, die entweder konkav oder konvex ist.

14. Folienanordnung nach einem der Ansprüche 1 bis 11, wobei sich die reflektierende Schicht über von 10 Prozent bis 90 Prozent einer Hauptoberfläche der Folienanordnung erstreckt.

15. Folienanordnung nach einem der Ansprüche 1 bis 14, wobei die reflektierende Schicht eine Dicke von 10 Nanometer bis 1000 Nanometer vorweist.

## Revendications

1. Ensemble de film comprenant les couches suivantes :
un affichage optique (104) configuré pour former une image :
une couche à persiennes (103) s'étendant à travers l'affichage optique et comprenant une pluralité de régions de transmission de lumière (110) et de régions d'absorption de lumière (112) agencées transversalement selon un motif bidimensionnel en alternance ; et
une couche réfléchissante (114) s'étendant à travers la couche à persiennes de telle sorte que la couche à persiennes est disposée entre l'affichage optique et la couche réfléchissante, dans lequel la couche réfléchissante est de préférence disposée sur les régions d'absorption de lumière pour réduire l'absorption de lumière incidente par les régions d'absorption de lumière, et **caractérisé en ce que** la couche réfléchissante est disposée sélectivement sur les régions d'absorption de lumière et n'est pas disposée sur les régions de transmission de lumière.

2. Ensemble de film selon la revendication 1, dans lequel la couche réfléchissante est une couche réfléchissante à large bande.

3. Ensemble de film selon la revendication 1, dans lequel la couche réfléchissante est un réflecteur spécifique à la longueur d'onde.

4. Ensemble de film selon la revendication 3, dans lequel la couche réfléchissante réfléchit sélectivement la lumière en dehors du spectre de la lumière visible.

5. Ensemble de film selon l'une quelconque des revendications 1 à 4, dans lequel l'affichage optique comprend
une source de lumière ; et
un panneau à cristaux liquides s'étendant à travers la source de lumière.

6. Ensemble de film selon l'une quelconque des revendications 1 à 4, dans lequel l'affichage optique comprend un réseau de diodes électroluminescentes organiques, une microdiode électroluminescente ou une minidiode électroluminescente.

7. Ensemble de film selon l'une quelconque des revendications 1 à 6, dans lequel les régions d'absorption de lumière sont effilées le long de leur dimension d'épaisseur lorsqu'elles sont vues en coupe transversale.

8. Ensemble de film selon la revendication 7, dans lequel la couche à persiennes possède une première surface principale faisant face à la couche réfléchissante et une seconde surface principale faisant face à l'affichage optique, et en outre dans lequel les régions d'absorption de lumière sont les plus larges le long de la première surface principale.

9. Ensemble de film selon la revendication 7, dans lequel la couche à persiennes possède une première surface principale faisant face à la couche réfléchissante et une seconde surface principale faisant face à l'affichage optique, et en outre dans lequel les régions d'absorption de lumière sont les plus larges le long de la seconde surface principale.

10. Ensemble de film selon la revendication 8 ou 9, dans lequel les régions d'absorption de lumière possèdent un angle d'inclinaison allant de -50 degrés à +50 degrés par rapport à un vecteur normal sur la première ou seconde surface principale.

11. Ensemble de film selon l'une quelconque des revendications 1 à 10, dans lequel la couche réfléchissante vient directement en contact avec les régions d'absorption de lumière de la couche à persiennes.

12. Ensemble de film selon l'une quelconque des revendications 1 à 11, dans lequel la couche réfléchissante est orientée à un angle aigu par rapport à une surface principale de l'ensemble de film.

13. Ensemble de film selon l'une quelconque des revendications 1 à 11, dans lequel la couche réfléchissante a une surface exposée qui est soit concave, soit convexe.

14. Ensemble de film selon l'une quelconque des revendications 1 à 11, dans lequel la couche réfléchissante s'étend sur 10 pour cent à 90 pour cent d'une surface principale de l'ensemble de film.

15. Ensemble de film selon l'une quelconque des revendications 1 à 14, dans lequel la couche réfléchissante possède une épaisseur allant de 10 nanomètres à 1000 nanomètres.
